Europäisches Patentamt

European Patent Office

Office européen des brevets

(19)

(11) Veröffentlichungsnummer: **0 265 435**
**B1**

(12) **EUROPÄISCHE PATENTSCHRIFT**

(45) Veröffentlichungstag der Patentschrifft:
07.02.90

(21) Anmeldenummer: 86904785.2

(22) Anmeldetag: 13.08.86

(86) Internationale Anmeldenummer:
PCT/DE 86/00329

(87) Internationale Veröffentlichungsnummer:
WO 87/01533 (12.03.87 Gazette 87/06)

(51) Int. Cl.⁵: **H 03 K   5/08, H 03 G   11/00**

(54) SCHALTUNGSANORDUNG ZUM SCHUTZ GEGEN AUF SIGNALLEITUNGEN AUFTRETENDEN STÖRSPANNUNGEN.

(30) Priorität: 05.09.85 DE 3531645

(43) Veröffentlichungstag der Anmeldung:
04.05.88 Patentblatt 88/18

(45) Bekanntmachung des Hinweises auf die Patenterteilung:
07.02.90 Patentblatt 90/06

(84) Bennante Vertragsstaaten:
DE FR IT

(56) Entgegenhaltungen:
EP-A-0 153 492
US-A-4 027 177

(73) Patentinhaber: ROBERT BOSCH GMBH
Postfach 50
D-7000 Stuttgart 1 (DE)

(72) Erfinder: KALKHOF, Bernd
Am Rosenbach 10
D-7410 Reutlingen (DE)

2

### Beschreibung

Die Erfindung betrifft eine monolithisch integrierte Schaltungsanordnung nach der Gattung des unabhängigen Anspruch.

Aus der DE-OS-3 240 280 ist bereits eine Schutzschaltung für Analog- und Digitalsignale bekannt. Diese Analog- und Digitalsignale sind für einen Eingang eines durch elektrische Signale gesteuerten Geräts bestimmt, das gegen positive und/oder negative Überspannungen bzw. Störspannungen gesichert wird. Problematisch an einer solchen Schutzschaltung ist eine Nichtlinearität des Eingangswiderstandes des zu schützenden Geräts von ca. 100 Millivolt pro Stromdekade des Eingangsstromes. Damit verbunden ist eine starke Temperaturabhängigkeit des Eingangswiderstandes, die eine Verfälschung etwa eines Meßergebnisses bewirken kann.

Aus der US-A-4 027 177 und aus der EP-A-153 492 sind ferner bereits monolithisch integrierte Schaltungsanordnungen nach der Gattung des Hauptanspruchs bekannt. Diese haben jedoch den Nachteil, daß beim Auftreten von Störspannungen die im Spannungsbegrenzer auftretende Verlustleistung so hoch werden kann, daß der Spannungsbegrenzer infolge Überlastung zerstört wird.

### Vorteile der Erfindung

Die erfindungsgemäße Schaltungsanordnung mit den kennzeichnenden Merkmalen des unabhängigen Anspruchs hat demgegenüber den Vorteil, daß beim Auftreten von Störspannungen der zusätzliche Begrenzungstransistor im wesentlichen den zur Klammerung erforderlichen Ausgangsstrom übernimmt, wodurch eine Zerstörung des Spannungsbegrenzers im Klammerbetrieb vermieden wird. Hierbei kann die Emitterfläche des zusätzlichen Begrenzungstransistors ein Vielfaches der Emitterfläche des zugeordneten Ausgangstransistors des zweiten Stromspiegels betragen. Besonders vorteilhaft ist es, wenn hierbei der Vorstrom am Kollektor des Ausgangstransistors des zweiten Stromspiegels eingeprägt ist.

Im Normalbetrieb, solange keine Störspannung auftritt, ist der zusätzliche Begrenzungstransistor nichtleitend, so daß lediglich ein kleiner Vorstrom durch den wesentlich kleineren Ausgangstransistor des zweiten Stromspiegels fließt. Die Verlustleistung wird durch diese Maßnahme besonders klein gehalten.

Da der zusätzliche Begrenzungstransistor nahezu den gesamten zur Klammerung erforderlichen Ausgangsstrom übernimmt, können die Emitterflächen der Stromspiegeltransistoren klein gehalten werden, so daß gegenüber einer Lösung ohne zusätzlichen Begrenzungstransistor eine beträchtliche Platzersparnis für die gesamte integrierte Schaltungsanordnung erhalten wird.

Um eine Spannungsbegrenzung bezüglich einer oberen und einer unteren Begrenzungsspannung zu erhalten, kann die Schaltungsanordnung ein zweites Stromspiegelpaar besitzen, welches gleichermaßen einen Ausgangstransistor mit parallel geschaltetem zusätzlichem Begrenzungstransistor besitzt.

### Zeichnung

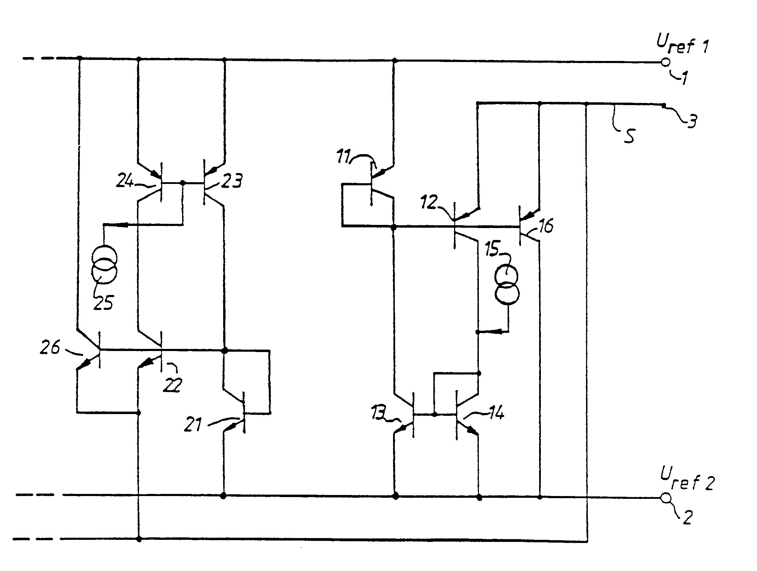

Ein Ausführungsbeispiel der Erfindung ist in der Zeichnung dargestellt und in der nachfolgenden Beschreibung näher erläutert. Das dargestellte Ausführungsbeispiel umfaßt zwei Stromspiegelpaare, die die Spannung auf einer Signalleitung S auf zwei Spannungswerte $U_{ref1}$ und $U_{ref2}$ begrenzen. Diese Bezugsspannungen $U_{ref1}$, $U_{ref2}$ liegen an Klemmen 1, 2 an, während die Signalleitung S mit einer Klemme 3 verbunden ist, an die beispielsweise ein hier nicht dargestellter Analog-Digital-Wandler angeschlossen sein kann.

Die zweite Bezugsspannung $U_{ref2}$ kann dem Massepotential entsprechen, während die erste Bezugsspannung $U_{ref1}$ positiver als die zweite Bezugsspannung ist.

Das Ausführungsbeispiel weist zwei Schaltungshälften auf, die jeweils eine komplementäre Stromspiegelschaltung umfassen. Die rechte Schaltungshälfte mit den Bauteilen 11 bis 16 dient zum Schutz gegen Überspannungen, die die erste Bezugsspannung $U_{ref1}$ übersteigen, während die linke Schaltungshälfte mit den Bauteilen 21 bis 26 zum Schutz gegen Störspannungen dient, die die zweite Bezugsspannung $U_{ref2}$ unterschreiten.

Ein erster Transistor 11 und ein zweiter Transistor 12, die beide vom pnp-Typ sind, bilden einen ersten Stromspiegel. Beim Transistor 11 sind Basis und Kollektor kurzgeschlossen, so daß dieser Transistor 11 als Diode wirkt. Der Kollektor des Transistors 11 ist an die Basis des als Ausgangstransistor dienenden Transistor 12 angeschlossen. Dessen Emitter ist mit der Signalleitung S verbunden. Die Kollektoren der Transistoren 11 und 12 sind mit den Kollektoren zweier weiterer Transistoren 13 und 14 verbunden, die einen zweiten Stromspiegel bilden, der gegenüber dem ersten Stromspiegel komplementär ausgebildet ist. Die Emitter der beiden als npn-Transistoren ausgebildeten Transistoren 13, 14 sind mit der zweiten Bezugsspannung $U_{ref2}$ verbunden. Die Basis des Transistors 14 ist mit dessen Kollektor kurzgeschlossen und liegt gleichzeitig an der Basis des Transistors 13 an. An der Verbindung zwischen den Kollektoren der beiden Transistoren 12 und 14 wird über eine Stromquelle 15 ein durch den Transistor 14 fließender positiver Strom eingespeist, wodurch eine ständige Vorströmung erzeugt wird, die den als Ausgangstransistor dienenden Transistor 12 ständig auf einen günstigen Arbeitspunkt einstellt.

Der Basis-Emitterstrecke des Transistors 12 ist die Basis-Emitterstrecke eines Begrenzungstransistors 16 parallel geschaltet, während der Kollektor des Begrenzungstransistors 16 an der als Konstantspannung dienenden Bezugsspannung $U_{ref2}$ liegt. Der Begrenzungstransistor 16 übernimmt bei einer auf der Signalleitung S auftretenden Überspannung den überwiegenden Teil des Stromes, der für die Klammerung bzw. für die Unterdrückung der Überspannung erforderlich ist. Der Begrenzungstransistor 16 besitzt eine um den Faktor n größere Emitterfläche als der Transistor 12, so daß sich die Verlustleistung gegenüber einer Anordnung ohne zusätzlichen Begrenzungstransistor um den Faktor (n + 1) verringert.

Die rechte Schaltungshälfte besteht insgesamt aus zwei übereinander geschalteten komplementären Stromspiegeln, wie sie u.a. aus der Zeitschrift "Funkschau", 26/1983, Seiten 44 ff, bekannt sind. Dabei stellt im unteren Stromspiegel der Transistor 14 einen Eingangs- und der Transistor 13 einen Ausgangstransistor dar. Entsprechend ist im oberen Stromspiegel der Transistor 11 ein Eingangsund der Transistor 12 eine Ausgangstransistor.

Die linke Schaltungshälfte besitzt eine entsprechende Schaltungsstruktur, wobei gegenüber der rechten Schaltungshälfte die npn-Transistoren in pnp-Transistoren und pnp-Transistoren in npn-Transistoren übergeführt sind. In ihrer Wirkung entsprechen die Transistoren 21, 22 den Transistoren 11, 12 sowie die Transistoren 23, 24 den Transistoren 13, 14. Dem Transistor 22 ist ein Begrenzungstransistor 26 zugeordnet, der wiederum dem Begrenzungstransistor 16 entspricht. An der Verbindungsstelle zwischen den Kollektoren der beiden Transistoren 22, 24 ist eine Stromquelle 25 angeschlossen, die einen Vorstrom entzieht bzw. einen negativen Strom einprägt.

Im Normalbetrieb, d.h. die auf der Signalleitung S auftretende Spannung liegt zwischen den Bezugsspannungen $U_{ref1}$ und $U_{ref2}$, fließt durch den Transistor 12 und gleichermaßen durch den Transistor 11 ein Vorstrom in der Größenordnung von einigen Mikroampere. Durch jeden der Transistoren 13 und 14 fließt ein entsprechender Vorstrom.

Nähert sich die auf der Signalleitung S auftretende Spannung dem Spannungswert der Bezugsspannung $U_{ref1}$, so wird der Transistor 16 leitend. Dabei fließt von der Klemme 3 über den Transistor 16 Strom zur Klemme 2 ab, wodurch die gewünschte Klammerung, die auch als Spannungsbegrenzung bezeichnet werden kann, eintritt. Durch die beiden übereinander angeordneten Stromspiegel, bestehend aus den Transistoren 11 bis 14, fließt insgesamt ein wesentlich geringerer Strom als durch den leistungsfähigeren Begrenzungstransistor 16. Für die linke Schaltungshälfte gilt dies gleichermaßen.

Die symmetrische Struktur der Transistoren 11, 12 zu den Transistoren 13, 14 bewirkt eine ausgezeichnete Temperaturkompensation der Begrenzerschwelle. Die gesamte Schaltungsanordnung ist in einfacher Weise integrierbar, wobei selbstverständlich auch die Verwendung von Transistoren mit Mehrfachemittern im Rahmen der Erfindung liegt.

## Patentansprüche

1. Monolithisch integrierte Schaltungsanordnung zum Schutz gegen auf Signalleitungen auftretenden Störspannungen mit mindestens einem zwei komplementäre, in Reihe angeordnete Stromspiegel enthaltenden Spannungsbegrenzer, bei dem die Emitter zweier Transistoren (13, 14; 23, 24) des ersten Stromspiegels an einer ersten Bezugsspannung ($U_{ref2}$; $U_{ref1}$) liegen, der Emitter des Ausgangstransistors (12; 22) des zweiten Stromspiegels mit der Signalleitung (S) verbunden ist, der Emitter des Eingangstransistors (11; 21) des zweiten Stromspiegels an einer zweiten Bezugsspannung ($U_{ref1}$; $U_{ref2}$) liegt und die beiden Stromspiegel ständig mittels eines Vorstroms aufgesteuert sind, dadurch gekennzeichnet, daß der Emitter-Basis-Strecke des Ausgangstransistors (12; 22) des zweiten Stromspiegels die Emitter-Basis-Strecke eines zusätzlichen Begrenzungstransistors (16; 26) parallelgeschaltet ist, dessen Kollektor mit der ersten Bezugsspannung ($U_{ref2}$; $U_{ref1}$) verbunden ist.

2. Schaltungsanordnung nach Anspruch 1 dadurch gekennzeichnet, daß die Emitterfläche des zusätzlichen Begrenzungstransistors (16; 26) ein Vielfaches der Emitterfläche des zugeordneten Ausgangstransistors (12; 22) des zweiten Stromspiegels beträgt.

3. Schaltungsanordnung nach Anspruch 1 oder 2, dadurch gekennzeichnet, daß der Vorstrom am Kollektor des Ausgangstransistors (12; 22) des zweiten Stromspiegels eingeprägt ist.

## Claims

1. Monolithically integrated circuit for protecting against interference voltages occurring on signalling lines with at least one voltage limiter containing two complementary current levels arranged in series, in which voltage limiter the emitters of two transistors (13, 14; 23, 24) of the first current level are connected to a first reference voltage ($U_{ref2}$; $U_{ref1}$), the emitter of the output transistor (12; 22) of the second current level is connected to the signalling line (S), the emitter of the input transistor (11; 21) of the second current level is connected to a second reference voltage ($U_{ref1}$; $U_{ref2}$) and the two current levels are continually maintained by means of a pre-current, characterized in that the emitter-base section of an additional limiting transistor (16; 26) is connected in parallel to the emitter-base section of the output transistor (12; 22) of the second current level, the collector of which limiting transistor is connected to the first reference voltage ($U_{ref2}$; $U_{ref1}$).

2. Circuit according to Claim 1, characterized in that the emitter surface of the additional limiting transistor (16; 26) is a multiple of the emitter surface of the assigned output transistor (12; 22) of the second current level.

3. Circuit according to Claim 1 or 2, characterized in that the pre-current is imprinted at the collector of the output transistor (12; 22) of the second current level.

**Revendications**

1. Circuit intégré monolithiquement, pour la protection contre les tensions parasites apparaissant sur les lignes de signalisation, circuit comportant au moins un limiteur de tension comprenant deux niveaux de courant complémentaires disposés en série, limiteur de courant dans lequel les émetteurs de deux transistors (13, 14; 23, 24) du premier niveau de courant sont à une première tension de référence ($U_{ref2}$; $U_{ref1}$), l'émetteur du transistor de sortie (12, 22) du second niveau de courant étant relié à la ligne de signalisation (S), l'émetteur du transistor d'entrée (11, 21) du second niveau de courant étant à une seconde tension de référence ($U_{ref1}$, $U_{ref2}$), et les deux niveaux de courant étant commandées en permanence par un courant préalable, circuit caractérisé en ce que, sur la section base-émetteur du transistor de sortie (12, 22) du second niveau de courant, est branchée en parallèle la section émetteur-base d'un transistor de limitation supplémentaire (16, 26), dont le collecteur est relié à la première tension de référence ($U_{ref2}$, $U_{ref1}$).

2. Circuit selon la revendication 1, caractérisé en ce que la surface d'émetteur du transistor de limitation supplémentaire (16, 26) est un multiple de la surface d'émetteur du transistor de sortie (12, 22) qui lui est associé, du second niveau de courant.

3. Circuit selon la revendication 1 ou 2, caractérisé en ce que le courant préalable est appliqué au collecteur du transistor de sortie (12, 22) du second niveau de courant.